# FASCICULE DE BREVET EUROPEEN

(11) **EP 1 111 688 B1**
(45) Date de publication et mention de la délivrance du brevet: **16.05.2007**
(21) Numéro de dépôt: 00410163.0
(22) Date de dépôt: 22.12.2000
(51) Int. Cl.: H01L 29/872, H01L 21/329

(54) **Diode schottky sur substrat de carbure de silicium**
Schottky-Diode auf Siliziumkarbid-Substrat
Schottky diode on silicon carbide substrate

(30) Priorité: 24.12.1999 FR 9916490
(43) Date de publication de la demande: 27.06.2001
(73) Titulaire: STMicroelectronics S.A., 92120 Montrouge (FR)
(72) Inventeur: Collard, Emmanuel, 37100 Tours (FR); Lhorte, André, 37550 Saint Avertin (FR)
(74) Mandataire: de Beaumont, Michel

(56) Documents cités:
- EP-A- 0 093 866
- WO-A-98/32178
- FR-A- 2 204 893
- US-A- 5 449 925
- US-A- 5 789 311

## Description

La présente invention concerne la réalisation d'une diode Schottky.

Dans le domaine des composants semiconducteurs, le matériau principalement utilisé à l'heure actuelle est le silicium. Pour la tenue de tensions très élevées, le carbure de silicium est a priori préférable car le carbure de silicium peut supporter des tensions par unité d'épaisseur environ 10 fois plus élevées que le silicium.

Toutefois, dans l'état actuel des technologies, les filières couramment utilisées pour la réalisation de composants à base de silicium ne sont pas transposables pour la réalisation de composants à base de carbure de silicium (SiC). En particulier, il n'est actuellement pas possible en pratique de réaliser des implantations et diffusions de dopants de type P dans du carbure de silicium dopé de type N, en notant que le dopant de type P couramment utilisé pour le carbure de silicium est de l'aluminium et le dopant de type N est de l'azote. En effet, un recuit pour diffusion d'une implantation d'un dopant de type P nécessiterait des températures de l'ordre de 1700°C, ce qui pose des problèmes technologiques aigus.

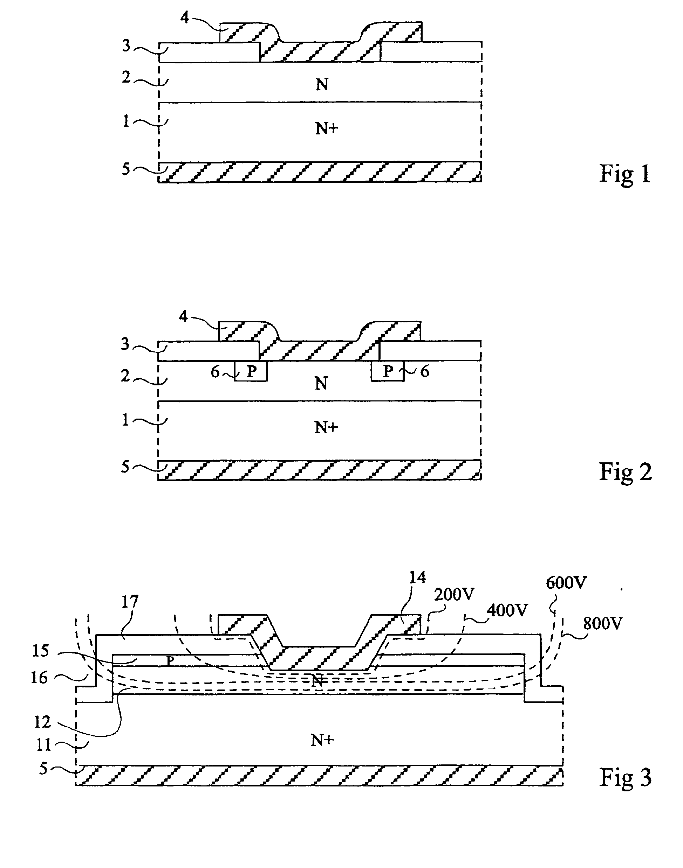

La structure élémentaire d'une diode Schottky est illustrée en figure 1. Cette diode est constituée à partir d'un substrat 1 de type N fortement dopé sur lequel est formée une couche épitaxiée 2 de type N convenablement dopée pour avoir le seuil Schottky souhaité. Sur cette couche épitaxiée N est déposé de l'oxyde de silicium 3 délimitant une fenêtre dans laquelle on veut établir le contact de Schottky au moyen d'une métallisation appropriée 4. La face arrière du composant est revêtue d'une métallisation 5.

Une telle structure présente une très mauvaise tenue en tension. En effet, les équipotentielles tendent à se recourber pour remonter vers la surface et il en résulte, notamment dans les zones de courbure des équipotentielles de très fortes variations de champ qui limitent la tenue en tension en inverse possible. Pour éviter cet inconvénient, on utilise classiquement dans le domaine des composants à base de silicium la structure représentée en figure 2 dans laquelle un anneau périphérique 6 de type P est formé à la périphérie de la zone de la diode Schottky. Il en résulte que les équipotentielles doivent passer en volume sous les régions P et présentent donc une courbure moins marquée. La tenue en tension de la diode en est considérablement améliorée. A titre d'exemple avec du silicium d'un niveau de dopage de 10¹⁶ at./cm³, on aura une tenue en tension de l'ordre de 10 V sans anneau de garde et de l'ordre de 50 V avec anneau de garde.

Toutefois, comme on l'a indiqué précédemment, la réalisation d'un tel anneau de garde de type P n'est pas réalisable dans une structure réalisée sur un substrat de carbure de silicium. Dans ce cas, la structure simple illustrée en figure 1 n'est pas non plus souhaitable pour les mêmes raisons que dans le cas d'un substrat de silicium. Les documents US-5,789,311 (correspondant au préambule de la revendication 1) et WO 98/32178 décrivent une diode Schottky verticale en carbure de silicium.

Ainsi, la présente invention vise à prévoir une structure de diode Schottky compatible avec des procédés de fabrication simples de carbure de silicium et qui permette une tenue en tension relativement élevée.

Pour atteindre ces objets, la présente invention prévoit une diode Schottky verticale comprenant une couche de carbure de silicium de type N à faible niveau de dopage formée par épitaxie sur un substrat de carbure de silicium à fort niveau de dopage, dans laquelle la périphérie de la zone active de la diode est revêtue d'une couche épitaxiée de carbure de silicium de type P ; une tranchée traverse la couche épitaxiée de type P et la couche épitaxiée de type N au-delà de la périphérie de la zone active ; le niveau de dopage de la couche épitaxiée de type P est choisi pour que, pour la tension maximale que la diode est susceptible de supporter, les équipotentielles correspondant à environ 1/4 à 3/4 de la tension maximale se prolongent jusqu'à la tranchée.

Selon un mode de réalisation de la présente invention, le niveau de dopage de la couche épitaxiée de type P est légèrement supérieur au dopage de la couche épitaxiée de type N.

Selon un mode de réalisation de la présente invention, la distance entre la périphérie externe de la zone active et la périphérie interne de la tranchée est de l'ordre de 30 à 60 *µ*m.

La présente invention vise aussi un procédé de fabrication d'une diode Schottky verticale sur un substrat de carbure de silicium fortement dopé de type N selon la revendication 1, comprenant les étapes consistant à former une couche épitaxiée faiblement dopée de type N ; former une couche épitaxiée dopée de type P ; creuser une tranchée périphérique ; déposer une couche isolante ; former une ouverture centrale traversant la couche isolante, la couche épitaxiée de type P et la couche épitaxiée de type N ; et déposer un métal susceptible de former une barrière Schottky avec la couche épitaxiée de type N.

Selon un mode de réalisation de la présente invention, le niveau de dopage de la couche épitaxiée de type P est choisi pour que, pour la tension maximale que la diode est susceptible de supporter, les équipotentielles correspondant à environ 1/4 à 3/4 de la tension maximale se prolongent jusqu'à la tranchée.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe simplifiée d'une diode Schottky élémentaire ;
la figure 2 est une vue en coupe simplifiée d'une diode Schottky classique sur substrat de silicium ; et
la figure 3 est une vue en coupe schématique d'une diode Schottky sur substrat de carbure de silicium selon la présente invention.

Conformément à l'usage dans le domaine de la représentation des semiconducteurs, les diverses couches des diverses figures ne sont pas tracées à l'échelle, ni dans leurs dimensions horizontales, ni dans leurs dimensions verticales.

La diode Schottky de la figure 3 est formée à partir d'une plaquette de carbure de silicium 11 fortement dopée de type N. Le dopant de type N est par exemple de l'azote. Sur la plaquette 11 est formée une couche mince épitaxiée 12 de type N plus faiblement dopée. Pour une tenue en tension recherchée de l'ordre de 600 à 1000 V, cette couche épitaxiée aura une épaisseur de l'ordre de 3 à 6 *µ*m. Le contact Schottky est formé entre cette couche 12 et une métallisation 14, par exemple un siliciure de platine, de titane ou de nickel ou autre. La face arrière de la plaquette 11 est revêtue d'une métallisation 5 correspondant à la cathode de la diode.

Selon l'invention, avant de réaliser le dépôt de la métallisation 14, on procède successivement aux étapes suivantes :
formation d'une couche mince épitaxiée 15 de carbure de silicium dopée de type P, le dopant étant par exemple de l'aluminium,
formation d'une tranchée périphérique 16 ayant sensiblement la profondeur de la somme des épaisseurs des couches épitaxiées 12 et 15,
dépôt d'une couche d'un isolant de protection 17, par exemple de l'oxyde de silicium, et
formation d'une ouverture centrale dans laquelle est formée la couche de métal Schottky 14 qui est donc en contact avec la couche N 12 et qui polarise la couche P 15.

La distance entre la périphérie de contact Schottky et la tranchée est de l'ordre de 30 à 60 *µ*m, par exemple de 40 *µ*m.

Le dopage de la région 15 de type P est choisi pour que, quand une tension voisine de la tension maximum que doit supporter la diode en inverse est appliquée à celle-ci, les équipotentielles au lieu de remonter toutes vers la surface s'étendent au moins partiellement jusqu'à la zone de la tranchée 16. On cherche par exemple à obtenir que, quand la tension inverse maximale est appliquée, l'équipotentielle correspondant à une valeur comprise entre 1/4 et 3/4 de la tension maximale atteigne la tranchée. En évitant ainsi que les équipotentielles soient trop rapprochées, et qu'elles présentent des courbures trop prononcées, on évite qu'il existe dans le composant, ou dans l'isolant qui l'entoure, des zones où les champs soient trop importants. Une solution proche de l'idéal est celle illustrée par les équipotentielles représentées en pointillés en figure 3. Pour une diode pouvant supporter 800 à 1000 V, on a représenté quatre équipotentielles correspondant à quatre valeurs également réparties du potentiel, par exemple des valeurs proches de 200, 400, 600 et 800 V. On notera que l'équipotentielle correspondant sensiblement à 600 V atteint la tranchée.

La façon dont sont réparties les lignes de champ dépendra essentiellement du niveau de dopage de la couche épitaxiée de type P qui par contre pourra être très mince et avoir une épaisseur de l'ordre de 1 à 3 *µ*m.

L'homme de l'art saura choisir le niveau de dopage optimal de la courbe épitaxiée de type P, en fonction notamment de la tension de claquage visée et du dopage et de l'épaisseur de la couche épitaxiée de type N, en utilisant des procédés de simulation connus, par exemple en utilisant le programme de simulation ISE-DESSIS.

Plus particulièrement, la tension inverse appliquée étant de l'ordre de 800 V, pour une épitaxie de type N d'une épaisseur de 3 à 6 *µ*m, pour une épitaxie de type P d'une épaisseur de l'ordre de 1 à 3 *µ*m, et pour une tranchée allant sensiblement jusqu'au fond de l'épitaxie de type N, la demanderesse a montré que l'on obtenait les résultats suivants :
1) pour une épitaxie de type N de 6.10¹⁵ at./cm³ et une épitaxie de type P de 5.10¹⁵ at./cm³, toutes les équipotentielles se recourbent vers la surface, y compris 1'équipotentielle 800 V, avant d'atteindre la tranchée ;
2) pour une épitaxie de type N de 10¹⁶ at./cm³ et une épitaxie de type P de 5.10¹⁶ at./cm³, une partie des équipotentielles, à partir de l'équipotentielle 600 V, atteint la tranchée ;
3) pour une épitaxie de type N de 10¹⁶ at./cm³ et une épitaxie de type P de 10¹⁸ at./cm³, toutes les équipotentielles atteignent la tranchée, aucune ne remontant vers la surface.

Selon la présente invention, on préfère une structure correspondant au deuxième cas. En effet, si toutes les équipotentielles remontent vers la surface ou si toutes les équipotentielles vont jusqu'à la tranchée, il faut que l'isolant déposé en surface (couramment de l'oxyde de silicium) ait une particulièrement bonne tenue en tension, c'est-à-dire soit déposé avec des contraintes de qualité particulièrement importantes pour pouvoir résister aux champs transversaux intenses qui y sont appliqués.

On peut déduire des exemples ci-dessus que pour se trouver dans ce deuxième cas, il convient que le dopage de la couche de type P soit légèrement supérieur au dopage de la couche de type N, par exemple 2 à 10 fois plus grand.

Bien entendu, la présente invention est susceptible de diverses variantes et modifications qui apparaîtront à l'homme de l'art, en particulier en ce qui concerne les dimensions des diverses couches, tant verticalement qu'horizontalement.

## Revendications

1. Diode Schottky verticale comprenant une couche de carbure de silicium (12) de type N à faible niveau de dopage formée par épitaxie sur un substrat de carbure de silicium (11) à fort niveau de dopage,
la périphérie de la zone active de la diode étant revêtue d'une couche épitaxiée (15) de carbure de silicium de type P ;
une tranchée (16) traversant la couche épitaxiée de type P au-delà de la périphérie de la zone active, **caractérisée en ce que** : la tranchée traverse la couche épitaxiée de type N;
le niveau de dopage de la couche épitaxiée de type P est choisi pour que, pour la tension maximale que la diode est susceptible de supporter, les équipotentielles correspondant à environ 1/4 à 3/4 de la tension maximale se prolongent jusqu'à la tranchée.

2. Diode Schottky selon la revendication 1, **caractérisée en ce que** le niveau de dopage de la couche épitaxiée de type P est légèrement supérieur au dopage de la couche épitaxiée de type N.

3. Diode Schottky selon la revendication 1 ou 2, **caractérisée en ce que** la distance entre la périphérie externe de la zone active et la périphérie interne de la tranchée est de l'ordre de 30 à 60 µm.

4. Procédé de fabrication d'une diode Schottky verticale selon la revendication 1 sur un substrat (11) de carbure de silicium fortement dopé de type N, **caractérisé en ce qu'**il comprend les étapes suivantes :
former une couche épitaxiée (12) faiblement dopée de type N ;
former une couche épitaxiée (15) dopée de type P ;
creuser une tranchée périphérique (16) ;
déposer une couche isolante (17) ;
former une ouverture centrale traversant la couche isolante (17), la couche épitaxiée (15) de type P et la couche épitaxiée (12) de type N ; et
déposer un métal susceptible de former une barrière Schottky avec la couche épitaxiée de type N.

5. Procédé selon la revendication 4, **caractérisé en ce que** le niveau de dopage de la couche épitaxiée de type P est choisi pour que, pour la tension maximale que la diode est susceptible de supporter, les équipotentielles correspondant à environ 1/4 à 3/4 de la tension maximale se prolongent jusqu'à la tranchée.

## Claims

1. A vertical Schottky diode including an N-type silicon carbide layer (12) of low doping level formed by epitaxy on a silicon carbide substrate (11) of high doping level,
the periphery of the active area of the diode being coated with a P-type epitaxial silicon carbide layer (15);
a trench (16) crossing the P-type epitaxial layer beyond the periphery of the active area;
**characterized in that** the trench crosses the N-type epitaxial layer, the doping level of the P-type epitaxial layer is chosen so that, for the maximum voltage that the diode is likely to be subjected to the equipotential surfaces corresponding to approximately 1/4 to 3/4 of the maximum voltage extend up to the trench.

2. The Schottky diode of claim 1, wherein the doping level of the P-type epitaxial layer is slightly greater than the doping level of the N-type epitaxial layer.

3. The Schottky diode of claim 1 or 2, wherein the distance between the external periphery of the active area and the internal periphery of the trench is on the order of 30 to 60 µm.

4. A method for manufacturing a vertical Schottky diode according to claim 1 on a heavily-doped N-type silicon carbide substrate (11), including the steps of:
forming a lightly-doped N-type epitaxial layer (12);
forming a P-type epitaxial layer (15);
digging a peripheral trench (16);
depositing an insulating layer (17);
forming a central opening crossing the insulating layer (17), the P-type epitaxial layer (15) and the N-type epitaxial layer (12); and
depositing a metal capable of forming a Schottky barrier with the N-type epitaxial layer.

5. The method of claim 4, wherein the doping level of the P-type epitaxial layer is chosen so that, for the maximum voltage that the diode is likely to be subjected to the equipotential surfaces corresponding to approximately 1/4 to 3/4 of the maximum voltage extend up to the trench.

## Patentansprüche

1. Vertikale Schottky-Diode, die Folgendes aufweist:
eine N-Typ Siliziumkarbidschicht (12) mit niedrigem Dotierniveau, die durch Epitaxie auf einem Siliziumkarbidsubstrat (11) mit hohem Dotierniveau ausgebildet ist, wobei der Umfang des aktiven Bereichs der Diode mit einer P-Typ Epitaxialsiliziumkarbidschicht (15) beschichtet ist;
einen Graben (16), der die P-Typ Epitaxialsiliziumkarbidschicht kreuzt, und zwar über den Umfang des aktiven Bereichs hinaus;
**dadurch gekennzeichnet, dass** der Graben die N-Typ Epitaxialschicht kreuzt, wobei das Dotierniveau der P-Typ Epitaxialschicht so ausgewählt ist, dass für die maximale Spannung der die Diode wahrscheinlich ausgesetzt wird, sich die Equipotentialoberflächen, welche ungefähr ein Viertel bis Dreiviertel der Maximalspannung entsprechen, sich bis zu dem Graben erstrecken.

2. Schottky-Diode nach Anspruch 1, wobei das Dotierniveau der P-Typ Epitaxialschicht etwas größer ist als das Dotierniveau der N-Typ Epitaxialschicht.

3. Schottky-Diode nach Anspruch 1 oder 2, wobei der Abstand zwischen dem Außenumfang des aktiven Bereichs und dem Innenumfang des Grabens in der Größenordnung von 30 bis 60 µm liegt.

4. Verfahren zur Herstellung einer vertikalen Schottky-Diode gemäß Anspruch 1 auf einem stark dotierten N-Typ Siliziumkarbidsubstrat (11), wobei das Verfahren die folgenden Schritte aufweist:
Ausbilden einer leicht dotierten N-Typ Epitaxialschicht (12);
Ausbilden einer P-Typ Epitaxialschicht (15);
Ausgraben eines Umfangsgrabens (16);
Abscheiden einer Isolierschicht (17);
Ausbilden einer Mittelöffnung, welche die Isolierschicht (17), die P-Typ Epitaxialschicht (15) und die N-Typ Epitaxialschicht (12) kreuzt; und
Abscheiden eines Metalls, das in der Lage ist eine Schottky-Barriere mit der N-Typ Epitaxialschicht zu bilden.

5. Verfahren nach Anspruch 4, wobei das Dotierniveau der P-Typ Epitaxialschicht so ausgewählt ist, dass für die maximale Spannung der die Diode voraussichtlich ausgesetzt wird, sich die Equipotentialoberflächen, die ungefähr ein Viertel bis Dreiviertel der Maximalspannung entsprechen, sich bis zu dem Graben erstrecken.
